Europäisches Patentamt

European Patent Office

Office européen des brevets

(11) Publication number: **0 442 145 A2**

# EUROPEAN PATENT APPLICATION

(21) Application number: 90125573.7

(51) Int. Cl.5: **H05K 1/03**

(22) Date of filing: **27.12.90**

(30) Priority: **16.02.90 JP 33855/90**

(43) Date of publication of application:
**21.08.91 Bulletin 91/34**

(84) Designated Contracting States:
**DE FR GB IT SE**

(71) Applicant: **JAPAN GORE-TEX, INC.**
**42-5, 1-chome Akazutsumi**
**Setagaya-ku Tokyo 156(JP)**

(72) Inventor: **Hazaki, Yoshito**
**353-1, Shukumo**
**Okayama-Ken 704(JP)**
Inventor: **Nomi, Haruo**
**1-15-9, Sakuragaoka-Nishi, Sanyou-Cho**
**Akaiwa-Gun, Okayama-Ken 709-08(JP)**
Inventor: **Hatakeyama, Minoru**
**7-1-22, Sakuragaoka-Nishi, Sanyou-Cho**
**Akaiwa-Gun, Okayama-Ken 709-08(JP)**

(74) Representative: **Klunker . Schmitt-Nilson .**
**Hirsch**
**Winzererstrasse 106**
**W-8000 München 40(DE)**

(54) **Printed circuit board.**

(57) A composite sheet for use in a printed circuit board, which comprises a sheet of fully densified polytetrafluoroethylene having polyimide resin particles distributed therein, said particles comprising 30 to 80 weight percent of the sheet.

# FIG.1

## PRINTED CIRCUIT BOARD

### FIELD OF THE INVENTION

The invention relates to a printed circuit board, and particular to an element or substrate useful in printed circuit boards.

### BACKGROUND OF THE INVENTION

Insulating materials used in the past in printed circuit substrates in the field of electrical devices, and particularly in large computers comprised:

(1) Glass/polyimide composite substrates in which a glass cloth was impregnated with a polyimide resin and then hardened.
(2) Glass/fluorine resin composite substrates in which a glass cloth was impregnated with a fluorine resin and then hardened.
(3) Porous polytetrafluoroethylene/polyimide resin varnish as described in USP 4,784,901.

In printed circuit substrates used in the field of electrical devices, and particularly large computers and the like, there is a need for faster signals and more layers in the substrate. In this respect, the insulating materials in the printed substrates from the above-mentioned prior art entail the following drawbacks. With the glass polyimide substrates (1), although their superior dimensional stability is ideal for multi-layer laminations, their dielectric constant is high at 4.3 to 4.7, so that they do not meet the objective of faster signal speed. Meanwhile, with the glass/fluorine resin substrates (2), while their dielectric constant is low at 2.5 to 3.0, because their coefficient of thermal expansion in the direction of tie Z axis (the multi-layer lamination direction), they are weak in terms of through-hole reliability when they are used in multi-layer sheets.

Thereupon, the objective of the present invention is to offer an insulating material with low dielectric constant and excellent dimensional stability when used as the insulating material in a printed circuit substrate.

### SUMMARY OF THE INVENTION

The present invention offers a printed circuit substrate which is characterized by the fact that a composite resin sheet formed by bonding polyimide resin particles in a polytetrafluoroethylene resin matrix is used as an insulating layer.

### BRIEF DESCRIPTION OF THE DRAWINGS

Figure 1 is a cross section of printed circuit substrate.
Figure 2 is a cross sectional, progressional diagram of a multi-layer printed circuit substrate.

### DETAILED DESCRIPTION OF THE DRAWINGS

Because fluorine resins generally have a low dielectric constant, a composite resin sheet with a low dielectric constant and excellent dimensional stability can be produced by using resin particles which have a relatively low dielectric constant and excellent dimensional stability for the filler resin particles. Polytetrafluoroethylene (PTFE), is such a resin.

Polyimide resins which have a lower dielectric constant than glass and superior dimentional stability.

The blend proportion between the PTFE and the polyimide resin particles used as the filler can be selected according to the desired dielectric constant and dimensional stability, but generally, the resins particles make up 30 to 80 wt %, with 50 to 70 wt % being preferable. If the amount of filler particles is too low, the dimensional stability will be lacking, and if the amount of filler particles is too high, the mechanical strength will be inadequate.

For the method for producing the sheet, a method can be employed in which a dispersion of PTFE is added to a dispersion of a resin, and the powder obtained through coagulation of the two is molded into a sheet form, and more specifically, is molded into a sheet form by means of, for example, roll-down after adding a lubricant.

The thickness of the sheet is generally 50 to 500 um.

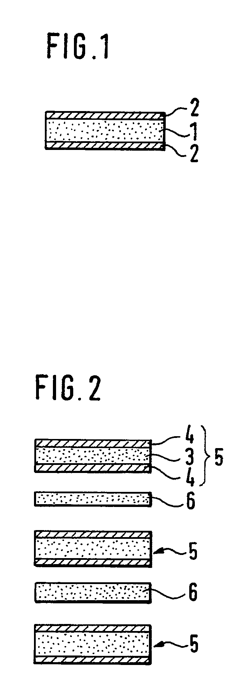

By using the composite resin sheet 1 produced in this manner as an insulating material, and fixing and molding the conductor 2 so as to form an electrical circuit on one or both sides of this sheet as shown in Figure 1, a printed circuit substrate is obtained. Further, as shown in the progressional diagram in Figure 2, a multi-layer printed substrate can be produced by laminating and integrating the copper clad sheets 5, in which the insulating material of the present invention is used as the core 3 and the copper foil 4, or through-hold formation in the insulating sheets 6 or the copper clad sheet 5 can be performed. The dimensional stability (low coefficient of thermal expansion) of the insulating material is important in forming multiple layers in this way.

**Example 1**

A polyimide resin powder was dispersed in pure water, and to this was added a polytetrafluoroethylene dispersion such that the polyimide resin made up 70 wt %. Coagulation of the two components produced polytetrafluoroethylene powder which contained the polyimide filler.

This powder was then dried at 160° C, after which a lubricant was added and a calendar roller was used to pressure roll the powder into a sheet. The lubricant was then removed through heating at 210° C, and the sheet was further subjected to a heat treatment at 350° C to produce an insulating substrate with a thickness of 100 um.

A circuit substrate was then produced by heat and pressure-bonding a copper foil with a thickness of 35 um to the above substrate.

**Comparative Examples 1 and 2**

In these examples, a commercially available glass/fluorine resin copper clad sheet (Comparative Example 1) and a glass/polyimide copper clad sheet (Comparative Example 2) were used.

The dielectic constants and the coefficients of linear expansion were measured for the above-mentioned circuit substrates, and the finding are given in the following table.

| | Example | Comparative Example 1 | Comparative Example 2 |
|---|---|---|---|
| Dielectric Constant (1 MHz) | 3.1 | 2.7 | 4.4 |
| Coefficent of Linear Expansion (Z axis direction)(ppm/°C) | 45 | 150 | 40 |

With the present invention, as discussed above, a printed circuit substrate can be obtained with a low dielectric constant and excellent dimensional stability, which is useful when used in large computers and other applications which require increased signal speed and multiple layers.

**Claims**

1. A composite sheet for use in a printed circuit board, which comprises a sheet of fully densified polytetrafluoroethylene having polyimide resin particles distributed therein, said particles comprising 30 to 80 weight percent of the sheet.

2. The sheet of Claim 1 wherein the particles comprise 50 to 70 weight percent.

# FIG.1

# FIG.2